# EUROPÄISCHE PATENTSCHRIFT

(11) **EP 1 058 965 B1**
(45) Veröffentlichungstag und Bekanntmachung des Hinweises auf die Patenterteilung: **26.09.2001**
(21) Anmeldenummer: 99910145.4
(22) Anmeldetag: 19.02.1999
(51) Int. Cl.: H03K 5/135

(54) **VORRICHTUNG ZUR AUSGABE DER ANTWORT EINES SYNCHRONEN SYSTEMS AUF EIN ASYNCHRONES EREIGNIS**
DEVICE FOR EMITTING THE RESPONSE OF A SYNCHRONOUS SYSTEM TO AN ASYNCHRONOUS EVENT
DISPOSITIF D'EMISSION DE LA REPONSE D'UN SYSTEME SYNCHRONE A UN EVENEMENT ASYNCHRONE

(30) Priorität: 05.03.1998 DE 19809439
(43) Veröffentlichungstag der Anmeldung: 13.12.2000
(73) Patentinhaber: Infineon Technologies AG, 81669 München (DE)
(72) Erfinder: SCHNEIDER, Peter, D-80333 München (DE); STEINECKE, Thomas, D-85457 Hofsingelding (DE)
(74) Vertreter: Zedlitz, Peter, Dipl.-Inf.
(86) Internationale Anmeldenummer: DE9900462
(87) Internationale Veröffentlichungsnummer: WO9945647

(56) Entgegenhaltungen:
- EP-A- 0 279 564
- EP-A- 0 652 658
- US-A- 5 148 533
- US-A- 5 168 546
- US-A- 5 519 700

## Beschreibung

Die vorliegende Erfindung betrifft eine Vorrichtung gemäß dem Oberbegriff des Patentanspruchs 1, d.h. eine Vorrichtung zur sofortigen Ausgabe der Antwort eines synchronen Systems auf ein asynchrones Ereignis.

Ein synchrones System ist ein System, dessen Zustand sich nur zu bestimmten (üblicherweise äquidistanten) Zeitpunkten ändert. Dabei handelt es sich beispielsweise um eine digitale Schaltung, bei der die sequentiellen Elemente (die Flip-Flops) und damit auch die die sequentiellen Elemente enthaltende Schaltung selbst ihren Zustand nur während der steigenden oder fallenden Flanke oder kurz danach (um die Gatterlaufzeiten verzögert) ändern. Die Zeitpunkte, zu denen Zustandsänderungen erfolgen können, werden nachfolgend als definierte Zustandswechsel-Zeitpunkte bezeichnet.

Im Unterschied hierzu ist ein asynchrones Ereignis ein Ereignis, das zu einem beliebigen Zeitpunkt auftreten kann.

Weil synchrone Systeme mitunter nur dann mit einem definierten Ergebnis auf Ereignisse reagieren (können), wenn diese nicht mehr oder weniger genau zu den definierten Zustandswechsel-Zeitpunkten eintreten, erweist es sich als vorteilhaft, wenn die asynchronen Ereignisse, genauer gesagt die solche Ereignisse signalisierenden Signale oder Signalveränderungen synchronisiert (eingephast) werden. Dies kann beispielsweise dadurch bewerkstelligt werden, daß dem Eingangsanschluß, über welchen das asynchrone Ereignis in das System eingegeben wird, ein Flip-Flop nachgeschaltet wird, wobei der Eingang dieses Flip-Flops und der asynchrone Eingangsanschluß des synchronen Systems miteinander verbunden werden. Da am Flip-Flop-Eingang angelegte Signale erst mit der steigenden oder fallenden Flanke eines Taktsignals an den Flip-Flop-Ausgang übernommen werden, ist am Flip-Flop-Ausgang ein synchrones (eingephastes) Signal verfügbar.

Auf diese Weise kann sichergestellt werden, daß das synchrone System überhaupt ordnungsgemäß auf asynchrone Ereignisse reagiert.

Die Antwort des synchronen Systems auf ein asynchrones Ereignis erfolgt in Regel jedoch nicht sofort, sondern mehr oder weniger später, denn synchrone Systeme können ihren Zustand ja nur zu den definierten Zustandswechsel-Zeitpunkten ändern.

In bestimmten Fällen ist es jedoch erforderlich, daß auf das Auftreten eines asynchronen Ereignisses sofort reagiert wird.

Um dies bei Verwendung eines synchronen Systems erreichen zu können, kann vorgesehen werden, diejenigen Teile des Systems, in die asynchrone Ereignisse eingegeben werden und denen die Erzeugung einer Antwort auf diese Ereignisse obliegt, asynchron zu betreiben. Ein asynchroner Betrieb der betreffenden System-Teile kann beispielsweise dadurch bewerkstelligt werden, daß das asynchrone Ereignis zugleich als Taktsignal für diese System-Teile benutzt wird, wodurch die Elemente der betreffenden System-Teile gleichzeitig mit dem Auftreten von asynchronen Ereignisses schalten. Dadurch kann erreicht werden, daß die Antwort auf asynchrone Ereignisse sofort vorliegt. Problematisch hierbei ist allerdings, daß der synchron arbeitende Teil des Systems und der asynchrone Teil desselben zu unterschiedlichen Zeitpunkten ihre Zustände wechseln und auf aufwendige Weise miteinander synchronisiert werden müssen.

Der vorliegenden Erfindung liegt daher die Aufgabe zugrunde, die Vorrichtung gemäß dem Oberbegriff des Patentanspruchs 1 derart weiterzubilden, daß dadurch auf einfache Weise eine sofortige Reaktion auf asynchrone Ereignisse möglich ist.

Diese Aufgabe wird erfindungsgemäß durch die im kennzeichnenden Teil des Patentanspruchs 1 beanspruchten Merkmale, also durch eine Vorausberechnungseinrichtung, durch welche die Antworten des synchronen Systems auf mögliche asynchrone Ereignisse vorausberechenbar sind, und durch eine Umschalteinrichtung, durch welche wahlweise das Ausgangssignal der Vorausberechnungseinrichtung oder das Ausgangssignal des synchronen Systems durchschaltbar ist, gelöst.

Dadurch kann das synchrone System weitestgehend unverändert "normal" weiterbetrieben werden. Daß dessen Antwort auf asynchrone Ereignisse erst mehr oder weniger lange nach dem Auftreten der asynchronen Ereignisse vorliegt, ist nicht von Nachteil, denn durch die Möglichkeit, zwischenzeitlich die von der Vorausberechnungseinrichtung vorausberechnete Antwort auszugeben, kann ja sofort und unabhängig vom synchronen System auf asynchrone Ereignisse reagiert werden. Die aktuell ermittelte Antwort des synchronen Systems muß nur so frühzeitig kommen, daß die Vorausberechnungseinrichtung genügend Zeit hat, noch vor dem Auftreten des nächsten asynchronen Ereignisses die Antwort auf dieses vorauszuberechnen.

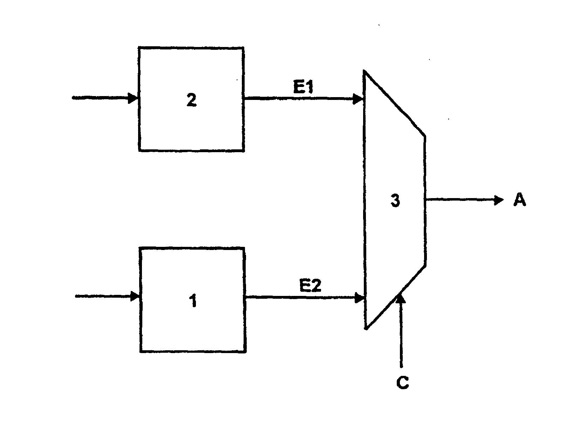

Vorteilhafte Weiterbildungen der Erfindung sind den Unteransprüchen, der nachfolgenden Beschreibung und der Figur entnehmbar.

Die Erfindung wird nachfolgend anhand eines Ausführungsbeispiels unter Bezugnahme auf die Figur näher beschrieben.

Die Figur zeigt schematisch den Aufbau eines Ausführungsbeispiels einer Vorrichtung zur sofortigen Ausgabe der Antwort eines synchronen Systems auf ein asynchrones Ereignis.

Die nachfolgend näher beschriebene Vorrichtung enthält ein "normales", d.h. synchron auf asynchrone Ereignisse reagierendes synchrones System.

Die asynchronen Ereignisse bzw. die diese signalisierenden Signale werden vor deren Verwendung durch das synchrone System vorzugsweise synchronisiert bzw. eingephast. Dazu wird das betreffende Ereignis so lange verzögert, daß es dem synchronen System erscheint, als fände das Ereignis zu einem definierten Zustandswechsel-Zeitpunkt statt. Dies wird vorliegend dadurch bewerkstelligt, daß dem Eingangsanschluß, über welchen das asynchrone Ereignis in das System eingegeben wird, ein Flip-Flop nachgeschaltet wird, wobei der Eingang dieses Flip-Flops und der asynchrone Eingangsanschluß des synchronen Systems miteinander verbunden werden. Da am Flip-Flop-Eingang angelegte Signale erst mit der steigenden oder fallenden Flanke eines Taktsignals an den Flip-Flop-Ausgang übernommen werden, ist am Flip-Flop-Ausgang ein synchrones (eingephastes) Signal verfügbar. Es erweist sich in der Regel als vorteilhaft, wenn hinter das besagte Flip-Flop mindestens ein weiteres Flip-Flop geschaltet wird; dadurch kann das Auftreten metastabiler Zustände verhindert werden.

In Fällen, in denen das synchrone System auch ohne Synchronisierung der asynchronen Ereignisse ordnungsgemäß auf diese reagiert, kann auf die Synchronisierung der asynchronen Ereignisse selbstverständlich verzichtet werden.

Um zu erreichen, daß das System sofort auf asynchrone Ereignisse reagieren kann, weist es zusätzlich eine Vorausberechnungseinrichtung und eine Umschalteinrichtung auf, wobei die Vorausberechnungseinrichtung dazu ausgelegt ist, die Antworten des synchronen Systems auf mögliche asynchrone Ereignisse vorauszuberechnen, und wobei die Umschalteinrichtung dazu ausgelegt ist, wahlweise selektiv entweder das Ausgangssignal der Vorausberechnungseinrichtung oder das Ausgangssignal des synchronen Systems durchzuschalten.

Der prinzipielle Aufbau einer derartigen Anordnung ist in der Figur veranschaulicht, wobei das synchrone System mit dem Bezugszeichen 1, die Vorausberechnungseinrichtung mit dem Bezugszeichen 2, und die Umschalteinrichtung mit dem Bezugszeichen 3 bezeichnet sind.

Die Umschalteinrichtung 3 kann beispielsweise ein Multiplexer sein und weist im betrachteten Beispiel Eingangsanschlüsse E1 und E2, einen Ausgangsanschluß A und einen Steueranschluß C auf, wobei der erste Eingangsanschluß E1 mit dem Ausgangsanschluß der Vorausberechnungseinrichtung 2 verbunden ist, und wobei der zweite Eingangsanschluß E2 mit dem Ausgangsanschluß des synchronen Systems 1 verbunden ist. Das am Ausgangsanschluß A der Umschalteinrichtung 3 ausgegebene Signal ist entweder das an deren Eingangsanschluß E1 oder das an deren Eingangsanschluß E2 anliegende Signal; welches der eingegebenen Signale durchgeschaltet wird, wird durch das an den Steueranschluß C angelegte Steuersignal bestimmt. Das Ausgangssignal A der Umschalteinrichtung 3 ist zugleich das Ausgangssignal der gesamten Vorrichtung; falls das in die Vorrichtung eingegebene (in der Figur nicht dargestellte) Signal ein ein asynchrones Ereignis signalisierendes Signal ist, repräsentiert das Ausgangssignal A der Umschalteinrichtung 3 die Antwort des synchronen Systems 1 auf das asynchrone Ereignis.

Das synchrone System 1 ist das vorstehend bereits beschriebene synchrone System.

Die Vorausberechnungseinrichtung 2 ist, wie vorstehend bereits angedeutet wurde, dazu ausgelegt, die Antwort auf ein Ereignis bereits im Voraus, also noch bevor das Ereignis auftritt, zu ermitteln; falls mehr als ein Ereignis auftreten kann, können für alle oder ausgewählte mehrere Ereignisse Antworten ermittelt und gleichzeitig an mehrere Eingangsanschlüsse der Umschalteinrichtung 3 oder bedarfsweise alternativ über einen oder relativ wenige Eingangsanschlüsse der Umschalteinrichtung 3 an diese angelegt werden.

Beim Auftreten eines asynchronen Ereignisses kann nun sofort die durch die Vorausberechnungseinrichtung 2 vorausberechnete Antwort ausgegeben werden; die schon an einem der Eingangsanschlüsse der Umschalteinrichtung 3 bereitstehende (vorzugsweise über ein Flip-Flop oder dergleichen dauerhaft angelegte) Antwort muß nur durch die Umschalteinrichtung 3 auf deren Ausgangsanschluß A durchgeschaltet werden, was über deren Steueranschluß C problemlos jederzeit und mit sofortiger Wirkung veranlaßbar ist.

Unter den gegebenen Umständen besteht für das synchrone System 1 kein Anlaß, asynchron auf das asynchrone Ereignis zu reagieren. Schließlich wird die Antwort auf das asynchrone Ereignis ja bereits seit dem Auftreten desselben ausgegeben. Nichtsdestotrotz reagiert auch das synchrone System auf das asynchrone Ereignis und kommt dabei zu dem selben Ergebnis wie die Vorausberechnungseinrichtung bei ihrer Vorausberechnung.

Sobald die Antwort des synchronen Systems vorliegt, wird sie an den Eingangsanschluß E2 der Umschalteinrichtung 3 gelegt und diese über den Steueranschluß C dazu veranlaßt, fortan dieses Signal auf den Ausgangsanschluß A durchzuschalten.

Weil die Antwort des synchronen Systems 1 auf das asynchrone Ereignis und die durch die Vorausberechnungseinrichtung 2 vorausbestimmte Antwort gleich sind (sie stammen lediglich aus verschiedenen Quellen), ändert sich dadurch am Ausgangsanschluß A der Umschalteinrichtung 3 nichts. Die Vorausberechnungseinrichtung kann dadurch jedoch mit der Vorausberechnung der Antwort auf das nächste asynchrone Ereignis bzw. der Antworten auf verschiedene nächste asynchrone Ereignisse beginnen.

Obgleich es nicht erforderlich ist, daß das synchrone System sofort auf das asynchrone Ereignis reagiert, darf es hierfür nicht beliebig lange brauchen. Die Antwortfindung muß so frühzeitig abgeschlossen sein, daß die Vorausberechnungseinrichtung noch ausreichend Zeit hat, um die Antwort auf das nächste asynchrone Ereignis oder die Antworten auf verschiedene asynchrone Ereignisse vor dem Auftreten derselben vorauszuberechnen.

Die vorstehend beschriebene Vorrichtung ist ganz offensichtlich für die unterschiedlichsten Zwecke einsetzbar.

Das asynchrone Ereignis bzw. das dieses signalisierende Signal kann dabei auch "nur" als Takt verwendet werden, mit dem beispielsweise Daten asynchron aus einem synchronen System herausgeschoben werden. In diesem Fall genügt es, das asynchrone Ereignis zur Ansteuerung der Umschalteinrichtung zu verwenden (an deren Steueranschluß C anzulegen).

Die betrachtete Anordnung ist nicht darauf beschränkt; in alleiniger Abhängigkeit von nur einem asynchronen Eingangssignal zu arbeiten; es können beliebig viele (synchrone und/oder asynchrone) Eingangssignale berücksichtigt werden. Dabei spielt es keine Rolle, ob die asynchronen Eingangssignale synchron zueinander sind.

Die beschriebene Vorrichtung ist im vorliegend betrachteten Beispiel ein elektrisches System. Es könnte sich jedoch auch um ein elektromechanisches oder mechanisches System handeln. Für derartige Systeme gelten die vorstehenden Ausführungen entsprechend; unter "Ein- und Ausgangssignale" mögen in diesem Fall jedoch mechanische Zustände verstanden werden.

Die beschriebene Vorrichtung ermöglicht es, daß Antworten synchroner Systeme auf asynchrone Ereignisse sofort nach deren Auftreten ausgebbär sind.

## Patentansprüche

1. Vorrichtung zur sofortigen Ausgabe der Antwort eines synchronen Systems (1) auf ein asynchrones Ereignis,
**gekennzeichnet durch**
eine Vorausberechnungseinrichtung (2), durch welche die Antworten des synchronen Systems auf mögliche asynchrone Ereignisse vorausberechenbar sind, und durch eine Umschalteinrichtung (3), durch welche wahlweise das Ausgangssignal der Vorausberechnungseinrichtung oder das Ausgangssignal des synchronen Systems durchschaltbar ist.

2. Vorrichtung nach Anspruch 1,
**dadurch gekennzeichnet,**
**daß** die Umschalteinrichtung (3) mindestens zwei Eingangsanschlüsse (E1, E2) aufweist, von welchen einer mit dem Ausgangsanschluß des synchronen Systems (1) und mindestens einer mit dem Ausgangsanschluß der Vorausberechnungseinrichtung (2) verbunden ist.

3. Vorrichtung nach Anspruch 2,
**dadurch gekennzeichnet,**
**daß** die Umschalteinrichtung (3) einen Steueranschluß (C) aufweist, über welchen festlegbar ist, welches der Eingangssignale durchgeschaltet werden soll.

4. Vorrichtung nach einem der vorhergehenden Ansprüche,
**dadurch gekennzeichnet,**
**daß** diese dazu ausgelegt ist, im Ansprechen auf das Auftreten eines asynchronen Ereignisses das Ausgangssignal der Vorausberechnungseinrichtung (2) auszugeben.

5. Vorrichtung nach einem der vorhergehenden Ansprüche,
**dadurch gekennzeichnet,**
**daß** diese dazu ausgelegt ist, das Ausgangssignal des synchronen Systems (1) auszugeben, sobald dieses die Antwort auf das Ereignis repräsentiert, auf welches mit der Ausgabe des Ausgangssignals der Vorausberechnungseinrichtung (2) reagiert wurde.

6. Vorrichtung nach einem der vorhergehenden Ansprüche,
**dadurch gekennzeichnet,**
**daß** das synchrone System (1) dazu ausgelegt ist, die Antwort auf das Ereignis, auf das es zu reagieren gilt, so frühzeitig auszugeben, daß die Vorausberechnungseinrichtung (2) noch ausreichend Zeit hat, um vor dem Auftreten eines nächsten Ereignisses die Antwort des synchronen Systems auf dieses vorherzusagen.

7. Vorrichtung nach einem der vorhergehenden Ansprüche,
**dadurch gekennzeichnet,**
**daß** die Vorausberechnungseinrichtung (2) dazu ausgelegt ist, durchzuführende Vorausberechnungen abzuschließen, bevor das Ereignis, für welches die Antwort des synchronen Systems (1) vorauszuberechnen ist, auftritt.

## Claims

1. Apparatus for immediately outputting the response of a synchronous system (1) to an asynchronous event,
**characterized by**
an advanced calculation device (2) by means of which the responses of the synchronous system to possible asynchronous events can be calculated in advance, and by a switching device (3) by means of which the output signal from the advanced calculation device or the output signal from the synchronous system can be passed on selectively.

2. Apparatus according to Claim 1,
**characterized in that**
the switching device (3) has at least two input connections (E1, E2), one of which is connected to the output connection of the synchronous system (1), and at least one of which is connected to the output connection of the advanced calculation device (2).

3. Apparatus according to Claim 2,
**characterized in that**
the switching device (3) has a control connection (C), via which it is possible to define which of the input signals is intended to be passed on.

4. Apparatus according to one of the preceding claims,
**characterized in that**
this apparatus is designed to output the output signal from the advanced calculation device (2) in response to the occurrence of an asynchronous event.

5. Apparatus according to one of the preceding claims,
**characterized in that**
this apparatus is designed to output the output signal from the synchronous system (1) as soon as this signal represents the response to the event which was responded to by outputting the output signal from the advanced calculation device (2).

6. Apparatus according to one of the preceding claims,
**characterized in that**
the synchronous system (1) is designed to output the response to the event which had to be responded to, sufficiently early that the advanced calculation device (2) still has sufficient time to predict the response of the synchronous system to a next event before it occurs.

7. Apparatus according to one of the preceding claims,
**characterized in that**
the advanced calculation device (2) is designed to complete advanced calculations that need to be carried out, before the occurrence of the event for which the response of the synchronous system (1) needs to be calculated in advance.

## Revendications

1. Dispositif pour émettre immédiatement la réponse d'un système (1) synchrone à un événement asynchrone, **caractérisé par** un dispositif (2) de calcul à l'avance par lequel les réponses du système synchrone à des événements asynchrones possibles peuvent être calculées à l'avance et par un dispositif (3) de commutation par lequel au choix le signal de sortie du dispositif de calcul à l'avance ou le signal de sortie du système synchrone peut être interconnecté.

2. Dispositif suivant la revendication 1, **caractérisé en ce que** le dispositif (3) de commutation comporte au moins deux bornes (E1, E2) d'entrée dont l'une est reliée à la borne de sortie du système (1) synchrone et dont au moins l'une est reliée à la borne de sortie du dispositif (2) de calcul à l'avance.

3. Dispositif suivant la revendication 2, **caractérisé en ce que** le dispositif (3) de commutation comporte une borne (C) de commande par l'intermédiaire de laquelle il peut être fixé celui des signaux d'entrée qui doit être interconnecté.

4. Dispositif suivant l'une des revendications précédentes, **caractérisé en ce que** celui-ci est conçu pour émettre le signal de sortie du dispositif (2) de calcul à l'avance en réponse à l'apparition d'un événement asynchrone.

5. Dispositif suivant l'une des revendications précédentes, **caractérisé en ce que** ce dispositif est conçu pour émettre le signal de sortie du système (1) synchrone dès que ce signal représente la réponse à l'événement auquel il a été réagi par l'émission du signal de sortie du dispositif (2) de calcul à l'avance.

6. Dispositif suivant l'une des revendications précédentes, **caractérisé en ce que** le système (1) synchrone est conçu pour émettre la réponse à l'événement auquel il s'agit de réagir de manière suffisamment précoce pour que le dispositif (2) de calcul à l'avance ait encore suffisamment de temps pour prévoir avant l'apparition d'un prochain événement la réponse du système synchrone à ce dernier.

7. Dispositif suivant l'une des revendications précédentes, **caractérisé en ce que** le dispositif (2) de calcul à l'avance est conçu pour achever des calculs à l'avance à effectuer avant que n'apparaisse l'événement pour lequel la réponse du système (1) synchrone est à calculer à l'avance.
